# EUROPEAN PATENT SPECIFICATION

(11) **EP 0 718 694 B1**
(45) Date of publication and mention of the grant of the patent: **15.05.2002**
(21) Application number: 95309146.9
(22) Date of filing: 15.12.1995
(51) Int. Cl.: G03F 7/029, G03C 7/12, G02B 5/22, G03F 7/00

(54) **Radiation-curable composition**
Durch Strahlen vernetzbare Zusammensetzung
Composition réticulable par irradiation

(43) Date of publication of application: 26.06.1996
(73) Proprietor: JAPAN SYNTHETIC RUBBER CO., LTD., Tokyo 104 (JP)
(72) Inventor: Nemoto, Hiroaki, Yokkaichi-shi (JP); Sakurai, Kouichi, Yokkaichi-shi (JP); Tajima, Yusuke, Bunkyo-ku, Tokyo (JP); Bessho, Nobuo, Aoba-ku, Yokohama-shi (JP)
(74) Representative: Lamb, Martin John Carstairs

(56) References cited:
- EP-A- 0 581 536
- GB-A- 2 259 704

## Description

### BACKGROUND OF THE INVENTION

This invention relates to a radiation-curable composition, more particularly to a radiation-curable composition suitable for producing a color filter to be used in a color liquid crystal display, an image pick-up tube device or the like.

In general, in a color liquid crystal display, a color image pick-up tube device and the like, a color filter in which pixel arrays of three primary colors of red, green and blue are arranged is used. However, as one of the processes for producing such a color filter, there has been known a process using a negative type radiation-curable composition having dispersed therein a pigment.

In this process, light screen layers are formed on the surface of a substrate so as to partition pixel-forming portions, and this substrate is coated with, for example, a red pigment-dispersed radiation-curable composition. Subsequently, the coating film thus obtained is irradiated with a curing radiation through a photomask, and then developed with, for example, an alkali developer to remove the unirradiated portions, thereby forming a red pixel array in which red pixels are arranged according to a specific pattern. Moreover, using a radiation-curable composition in which a green pigment is dispersed and a radiation-curable composition in which a blue pigment is dispersed, the above coating, irradiation and development are effected in the same manner as above to form a green pixel array and a blue pixel array, respectively, on the above substrate having formed thereon a red pixel array to obtain a color filter.

Heretofore, as the radiation-curable composition, there has been used a composition comprising a carboxyl group-containing binder polymer, a radical-polymerizable substance consisting of a polyfunctional acrylate such as pentaerythritol acrylate or the like, and a photo-radical generator. As the photo-radical generator, there has been used, for example, 1-hydroxycyclohexyl phenyl ketone or the like.

However, in the case of the above-mentioned radiation-curable composition, there is such a problem that in the development treatment in the course of producing a color filter, a substance which has not been dissolved in the developer (referred to hereinafter as the undissolved substance) remains in other portions than the pixel-forming portions.

As a result, the color filter obtained has a small overall light transmittance because of the presence of the undissolved substance, and hence, a color liquid crystal display in which the above color filter is used shows a low contrast in the displaying.

In particular, when in the portions in which the undissolved substance remains, pixels are formed in the subsequent step, the adhesion of said pixel-formers to the substrate becomes insufficient due to the presence of the undissolved substance, and hence, the pixels tend to fall off from the substrate and be broken.

Also, in the above radiation treatment, the intensity of the curing radiation in the coating film is attenuated because of absorption of radiation by the pigment or the like, so that such a phenomenon is necessarily caused that the intensity becomes low in places nearer to the substrate in the coating film. Accordingly, the bottom of the coating film tends to become in such a state that curing reaction is not sufficiently achieved. In this case, the bottom becomes hollowed by the development treatment and the pixels obtained come to have a so-called undercut. As a result, when a protective film is formed on the color filter, the undercut makes it impossible to sufficiently flatten the color filter or becomes, in some cases, the cause of disconnection of a transparent conductive film formed on the protective film.

Moreover, it is necessary to use a radiation of a large energy in the radiation treatment and when the amount of radiation irradiated is insufficient the curing reaction of the coating film does not proceed sufficiently, so that the yield of residual film thickness after the development treatment is too low and the strength of the pixels per se is too low. As a result, such a problem is raised that the pixels are damaged when a transparent conductive film and a liquid crystal-aligning film are formed on the color filter.

The above problems can be solved by irradiation with a sufficient energy amount of a radiation; however, in this case, the production efficiency becomes low.

### SUMMARY OF THE INVENTION

This invention has been made under such circumstances and aims at providing a radiation-curable composition which, when used, for example, in the production of a color filter, can effectively prevent the undissolved substance from being left in other portions than the pixel-forming portions in the development treatment and can produce with certainty undercut-free pixels in a high efficiency.

According to this invention, there is provided a radiation-curable composition which comprises (A) a binder polymer, (B) a polyfunctional monomer and (C) a photo-radical generator consisting of a compound represented by the following formula: 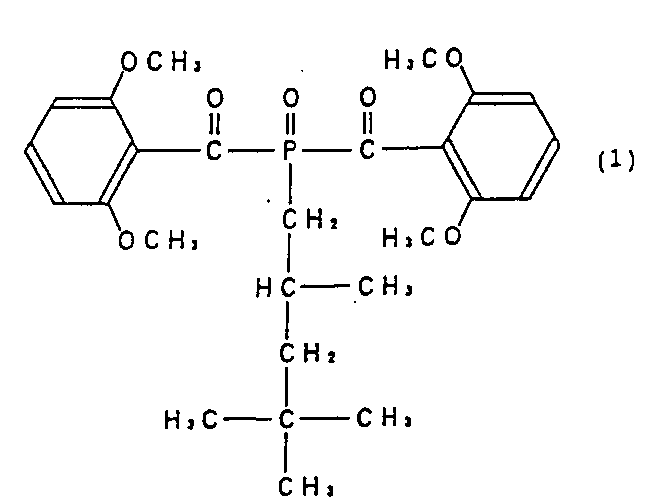 wherein the binder polymer (A) is a carboxyl group-containing copolymer obtained by polymerizing a monomer composition consisting of (A-1) a carboxyl-containing, ethylenically unsaturated monomer and (A-2) a comonomer copolymerizable with the carboxyl-containing, ethylenically unsaturated monomer (A-1): the monomer (A-1) being methacrylic acid, and the comonomer (A-2) being (A-2-1) benzyl methacrylate and (A-2-2) at least one member selected from the group consisting of polystyrene macromonomer having a terminal acryloyl group or methacryloyl group and hydroxy ethyl methacrylate.

Specific examples of the binder polymer include methacrylic acid/benzyl methacrylate/polystyrene macromonomer having a terminal acryloyl group or methacryloyl group copolymer, and methacrylic acid/benzyl methacrylate/hydroxyethyl methacrylate/ polystyrene macromonomer having a terminal acryloyl group or methacryloyl group copolymer.

The proportion of the carboxyl-containing, ethylenically unsaturated monomer (A-1) copolymerized in the component (A) is preferably 5 to 50% by weight, more preferably 10 to 40% by weight.

The copolymer containing the constitutive unit resulting from the above carboxyl-containing, ethylenically unsaturated monomer (A-1) has an alkali-solubility, and in particular, the copolymer obtained by use of the carboxyl-containing, ethylenically unsaturated monomer (A-1) in the above-mentioned proportion comes to have an excellent solubility in the alkali developer. Accordingly, when a radiation-curable composition comprising this copolymer as the component (A) is used, the production of a substance which is not dissolved in an alkali developer is essentially a little, and in the development treatment, scummings, residues are hardly generated in other portions than the pixel-forming portions of the substrate.

The pixels obtained when the above copolymer is used as the component (A) are not excessively dissolved in the alkali developer and have an excellent adhesiveness to the substrate, so that they hardly fall off from the substrate.

When the proportion of the carboxyl-containing, ethylenically unsaturated monomer (A-1) copolymerized in the component (A) is less than 5% by weight, the radiation-curable composition obtained tends to have a low solubility in an alkali developer. On the other hand, when the proportion of the carboxyl-containing, ethylenically unsaturated monomer (A-1) copolymerized is more than 50% by weight, there is the tendency that the pixels fall off from the substrate during the development. Also, there is the tendency that surface roughness on the pixel surface is easily caused.

The binder polymer used as the component (A) has preferably a polystyrene-reduced weight average molecular weight (referred to hereinafter merely as the weight average molecular weight) of 3,000 to 300,000, particularly preferably 5,000 to 100,000 as measured by a gel permeation chromatography (GPC, carrier: tetrahydrofuran).

When the binder polymer having such a molecular weight is used as the component (A), a radiation-curable composition having a high developability is obtained, whereby a pixel array having a sharp pattern edge can be formed and simultaneously scummings, residues become difficult to generate in other portions than the pixel-forming portions of the substrate in the development treatment.

Specific examples of the polyfunctional monomer which is the component (B) include trifunctional or more polyfunctional acrylates such as trimethylolpropane triacrylate, pentaerythritol triacrylate, trisacryloyloxyethyl phosphate, pentaerythritol tetraacrylate, dipentaerythritol pentaacrylate, dipentaerythritol hexaacrylate; and oligomers thereof.

Among them, trimethylolpropane triacrylate, dipentaerythritol pentaacrylate and pentaerythritol triacrylate are preferable because the pixel strength is high, the pixel surface is excellent in smoothness and scummings or residues are difficult to generate in other portions than the pixel-forming portions.

The proportion of the component (B) used is preferably 5 to 500 parts by weight, more preferably 20 to 300 parts by weight, per 100 parts by weight of the component (A).

When the above proportion is less than 5 parts by weight, the pixel strength or the smoothness of the pixel surface tends to become insufficient. On the other hand, when the proportion is more than 500 parts by weight, the alkali-resolvability becomes low and the scummings, residues tend to be generated in other portions than the pixel-forming portions.

In this invention, as the photo-radical generator which is the component (C), the compound represented by the above formula (1), that is, bis(2,6-dimethoxybenzoyl)-2,4,4-trimethylpentylphosphine oxide (referred to hereinafter as the specific compound in some cases) is used.

When a photo-radical generator consisting of the specific compound is contained, the curing reaction is sufficiently achieved by irradiation with a small energy amount of a radiation, and simultaneously, no curing reaction is caused in places not irradiated with the radiation. As a result, the coating film after the radiation treatment becomes in the state that there have been formed cured portions insoluble in an alkali developer and uncured portions highly soluble in an alkali developer.

The proportion of the specific compound [the component (C)] used is preferably 0.01 to 200 parts by weight, particularly preferably 1 to 120 parts by weight, per 100 parts by weight of the component (B).

When the above proportion is less than 0.01 part by weight, no sufficient curing reaction is effected in the radiation treatment, and undercut is formed in the pixels in some cases.

When the above proportion is more than 200 parts by weight, the pixels tend to fall off from the substrate during the development, and scummings, residues tend to be generated in other portions than the pixel-forming portions.

In this invention, the specific compound [the component (C)] can be used together with other photo-radical generators.

Specific examples of the said other photo-radical generators include 2-hydroxy-2-methyl-1-phenylpropan-1-one, 1-(4-isopropylphenyl)-2-hydroxy-2-methylpropan-1-one, 4-(2-hydroxyethoxy)phenyl 2-hydroxy-2-propyl ketone, 1-hydroxycyclohexyl phenyl ketone, 2,2-dimethoxy-2-phenylacetophenone, 2-methyl-(4-methylthiophenyl)-2-morpholino-1-propan-1-one, 2-benzyl-2-dimethylamino-1-(4-morpholinophenyl)butan-1-one, benzophenone, 4,4'-bis(dimethylamino)benzophenone, 4,4'-bis(diethylamino)benzophenone, 2,4-diethylthioxanthone, 3,3-dimethyl-4-methoxybenzophenone, 4-azidobenzaldehyde, 4-azidoacetophenone, 4-azidobenzalacetophenone, azidopyrene, 4-diazodiphenylamine, 4-diazo-4'-methoxy-diphenylamine, 4-diazo-3-methoxydiphenylamine, dibenzoyl, benzoin thioisobutyl ether, N-phenylthioacridone, triphenylpyrylium perchlorate, 2,4,6-tris(trichloromethyl)-1,3,5-triazine, 2-(4-methoxyphenyl)-4,6-bis(trichloromethyl)-1,3,5-triazine, 2-(2-furylethylidene)-4,6-bis(trichloromethyl)-1,3,5-triazine, 2-[2-(5-methylfuryl)ethylidene]-4,6-bis-(trichloromethyl)-1,3,5-triazine, 2-(4-methylthiophenyl)-4,6-bis(trichloromethyl)-1,3,5-triazine, 2-(2-furylethylidene)-4,6-bis(tribromomethyl)-1,3,5-triazine).

Among them, 2-hydroxy-2-methyl-1-phenylpropan-1-one, 2-methyl-(4-methylthiophenyl)-2-morpholino-1-propan-1-one and 2-benzyl-2-dimethylamino-1-(4-morpholinophenyl)butan-1-one are preferable in that the pixels do not fall off from the substrate during the development and a high pixel strength or sensitivity is obtained.

The proportion of the said other photo-radical generator used is preferably not more than 80% by weight based on the total weight of the photo-radical generators.

The radiation-curable composition of this invention is usually used in solution or dispersion in an organic solvent. The organic solvent may be any solvent as far as it is such that the components (A), (B) and (C) and the optionally added pigments and other components can be dissolved or dispersed in the solvent and the solvent does not react with these components and has a suitable volatility.

Specific examples of the said organic solvent (referred to hereinafter as the component (D) in some cases) includes (a") glycol ethers such as ethylene glycol monomethyl ether, ethylene glycol monoethyl ether; (b") ethylene glycol alkyl ether acetates such as ethylene glycol monomethyl ether acetate, ethoxyethyl acetate; (c") diethylene glycols such as diethylene glycol monomethyl ether, diethylene glycol monoethyl ether, diethylene glycol monobutyl ether; (d") propylene glycol alkyl ether acetates such as propylene glycol methyl ether acetate, propylene glycol ethyl ether acetate; (e") ethers such as diethylene glycol dimethyl ether, tetrahydrofuran; (f") ketones such as methyl ethyl ketone, cyclohexanone, 2-heptanone, 3-heptanone; (g") esters such as methyl 2-hydroxypropionate, ethyl 2-hydroxypropionate, ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methyl butyrate, 3-methyl-3-methoxybutyl acetate, 3-methyl-3-methoxybutyl propionate, 3-methyl-3-methoxybutyl butyrate, ethyl acetate, butyl acetate, amyl formate, isoamyl acetate, isobutyl acetate, butyl propionate, isopropyl butyrate, ethyl butyrate, butyl butyrate, methyl pyruvate, ethyl pyruvate, propyl pyruvate, methyl acetoacetate, ethyl acetoacetate, ethyl 2-oxobutanate; (f") aromatic hydrocarbons such as toluene, xylene.

Moreover, high boiling solvents can be co-used such as benzyl ethyl ether, dihexyl ether, acetonyl acetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl Cellosolve acetate.

These organic solvents may be used alone or in combination of two or more.

Among them, preferable are diethylene glycol dimethyl ether, ethylene glycol monomethyl ether acetate, propylene glycol methyl ether acetate, propylene glycol ethyl ether acetate, cyclohexanone, 2-heptanone, 3-heptanone, ethyl 2-hydroxypropionate, methyl 3-methoxypropionate, ethyl 3-methoxypropionate, methyl 3-ethoxypropionate, ethyl 3-ethoxypropionate, butyl acetate, amyl formate, isoamyl acetate, isobutyl acetate, butyl propionate, isopropyl butyrate, ethyl butyrate, butyl butyrate, ethyl pyruvate, γ-butyrolactone in view of solubility, pigment-dispersibility, coatability and the like.

The proportion of the organic solvent which is the component (D) is preferably 100 to 10,000 parts by weight, more preferably 500 to 5,000 parts by weight, per 100 parts by weight of the component (A).

In order to increase the solubility in an alkali developer of the coating film composed of the radiation-curable composition of this invention and decrease the amount of the undissolved substance left after the development treatment, an organic acid [component (E)] may be contained in the radiation-curable composition.

The component (E) is preferably an aliphatic carboxylic acid having at least one carboxyl group in the molecule and having a molecular weight of not more than 1,000 or a phenyl group-containing carboxylic acid having at least one carboxyl group in the molecule and having a molecular weight of not more than 1,000.

Specific examples of the aliphatic carboxylic acid include (i) monocarboxylic acids such as formic acid, acetic acid, propionic acid, butyric acid, valeric acid, pivalic acid, diethylacetic acid, enanthic acid; (ii) dicarboxylic acids such as oxalic acid, malonic acid, succinic acid, glutaric acid, adipic acid, pimelic acid, suberic acid, azelaic acid, sebacic acid, brassylic acid, methylmalonic acid, ethylmalonic acid, dimethylmalonic acid, methylsuccinic acid, tetramethylsuccinic acid, cyclohexane dicarboxylic acid, itaconic acid, citraconic acid, maleic acid, fumaric acid, mesaconic acid; (iii) tricarboxylic acids such as tricarballylic acid, aconitic acid, camphoronic acid.

As the phenyl group-containing carboxylic acid, there can be used aromatic carboxylic acids in which the carboxyl group is directly bonded to a phenyl group and carboxylic acids in which the carboxyl group is bonded through a carbon linkage to a phenyl group, and specific examples thereof include (i') aromatic monocarboxylic acids such as benzoic acid, toluic acid, cuminic acid, hemellitic acid, mesitylenic acid; (ii') aromatic polycarboxylic acids such as phthalic acid, isophthalic acid, terephthalic acid, trimellitic acid, trimesic acid, mellophanic acid, pyromellitic acid; (iii') phenylacetic acid, hydroxyatropic acid, hydroxycinnamic acid, mandelic acid, phenylsuccinic acid, atropic acid, cinnamic acid, cinnamyllideneacetic acid, coumaric acid, umbellic acid.

These organic acids can be used alone or in combination of two or more.

Among the above organic acids, preferable are aliphatic dicarboxylic acids and aromatic dicarboxylic acids such as adipic acid, malonic acid, citraconic acid, itaconic acid, mesaconic acid, fumaric acid, phthalic acid in respects of alkali-solubility, solubility in the organic solvents [the component (D)], inhibition of scummings from being generated.

The proportion of the component (E) used is preferably not more than 10% by weight, more preferably 0.001 to 10% by weight, and most preferably 0.01 to 1% by weight, based on the total weight of the composition including the organic solvent which is the component (D).

When the proportion of the component (E) used is more than 10% by weight, the pixels obtained from the radiation-curable composition tend to become low in adhesion to the substrate.

In the case of producing a color filter from the radiation-curable composition of this invention, a pigment is contained together with all the above-mentioned components in the composition. The pigment includes organic pigments and inorganic pigments.

As the organic pigment, there can be used, for example, carbon black and various compounds classified as pigments in Color Index (CI) published by The Society of Dyers and Colourists.

The inorganic pigment includes metallic compounds such as metal oxides, metal complexes and the like, and specifically, there can be used oxides and composite oxides of metals such as iron, cobalt, aluminum, cadmium, lead, copper, titanium, magnesium, chromium, zinc, antimony.

Specific examples of such pigments include, when indicated by Color Index numbers, C.I. Pigment Yellow 12, 13, 14, 16, 17, 24, 31, 53, 55, 81, 83, 106, 110, 154, 173, 174 and 176; C.I. Pigment Orange 36, 43 and 51; C.I. Pigment Red 9, 57:1, 105, 114, 144, 149, 176, 177 and 208; C.I. Pigment Violet 14, 19, 23 and 29; C.I. Pigment Blue 15, 15:1, 15:2, 15:3, 15:4, 15:6, 16, 22 and 28; C.I. Pigment Green 7, 15, 25 and 36; C.I. Pigment Brown 28; C.I. Pigment Black 1, 6, 7, 8, 9 and 11; C.I. Pigment White 6.

These pigments may be used alone or in admixture of two or more for toning.

The proportion of the pigment used is preferably 10 to 1,000 parts by weight, more preferably 20 to 500 parts by weight, per 100 parts by weight of the component (A) in the radiation-curable composition.

When this proportion is less than 10 parts by weight, it becomes difficult to obtain a sufficient color strength as a pixel for a color filter. On the other hand, when the proportion is more than 1,000 parts by weight, scummings and residues are generated in other portions than the pixel-forming portions in some cases.

The radiation-curable composition of this invention may further comprise a high molecular weight compound having a functional group in the main or side chain capable of functioning as a photocross-linking agent or photosensitizer.

Such a high molecular weight compound include specifically condensation products of 4-azidobenzaldehyde with polyvinyl alcohol, condensation products of 4-azidobenzaldehyde with phenol novolak resins, homopolymers or copolymers of 4-acryloyloxy-chalcone, 1,4-polybutadiene, 1,2-polybutadiene.

The proportion of such a photocross-linking agent or photosensitizer used is preferably 0.01 to 200 parts by weight, more preferably 50 to 180 parts by weight, per 100 parts by weight of the photo-radical generator.

Moreover, the radiation-curable composition of this invention may, if necessary, contain various additives.

Said additives include (I) fillers such as glass, aluminum; (II) high molecular weight compounds such as polyvinyl alcohol, polyethylene glycol monoalkyl ethers, polyfluoroalkyl acrylates; (III) surfactants such as nonionic surfactants, cationic surfactants, anionic surfactants; (IV) adhesion promoters such as vinyltrimethoxysilane, vinyltriethoxysilane, vinyltris(2-methoxyethoxy)silane, N-(2-aminoethyl)-3-aminopropylmethyldimethoxysilane, N-(2-aminoethyl)-3-aminopropyltrimethoxysilane, 3-aminopropyltriethoxysilane, 3-glycidoxypropyltrimethoxysilane, 3-glycidoxypropylmethyldimethoxysilane, 2-(3,4-epoxycyclohexyl)ethyltrimethoxysilane, 3-chloropropylmethyldimethoxysilane, 3-chloropropyltrimethoxysilane, 3-methacryloxypropyltrimethoxysilane, 3-mercaptopropyltrimethoxysilane; (V) antioxidants such as 2,2-thiobis(4-methyl-6-t-butylphenol), 2,6-di-t-butylphenol and the like; (VI) ultraviolet absorbers such as 2-(3-t-butyl-5-methyl-2-hydroxyphenyl)-5-chlorobenzotriazole, alkoxybenzophenones; (VII) flocculation inhibitors such as sodium polyacrylate.

As the curing radiation for curing the radiation-curable composition of this invention, it is preferable to use those containing lights having wavelengths ranging from 190 to 450 nm.

The energy amount of the radiation irradiated is preferably 1 to 1,000 mJ/cm².

As the alkali-developer, it is preferable to use an aqueous solution of an alkali such as sodium carbonate, sodium hydroxide, potassium hydroxide, tetramethylammonium hydroxide.

As the developing method, there can be adopted a shower developing method, a spray developing method, a dip developing method, a puddle developing method and the like, and the developing time is preferably 5 to 300 seconds.

When the radiation-curable composition of this invention is used, a color filter can be produced in the following manner:

Light screen layers are formed so as to partition pixel-forming portions on the surface of a substrate, this substrate is coated with, for example, a red pigment-dispersed radiation-curable composition and the resulting assembly is subjected to prebaking to vaporize the organic solvent, thereby forming a coating film. Thereafter, this coating film is irradiated with a curing radiation through a photomask to effect radiation treatment. Subsequently, the irradiated coating film is subjected to development treatment with an alkali developer to dissolve and remove the unirradiated portions of the coating film, thereby forming a red pixel array in which red pixels are arranged in a specific pattern.

In addition, using a green pigment-dispersed radiation-curable composition and a blue pigment-dispersed radiation-curable composition, the above red pixel array-formed substrate is subjected to coating treatment, prebaking treatment, radiation treatment and development treatment in the same manner as above to form a green pixel array and a blue pixel array, respectively, on the above substrate, thereby obtaining a color filter in which pixel arrays of three primary colors of red, green and blue are arranged.

Preferable modes of the radiation-curable composition of this invention are as follows:
(1) The radiation-curable composition in which the binder polymer (A) is a carboxyl group-containing copolymer obtained by polymerizing a monomer composition consisting of a carboxyl-containing, ethylenically unsaturated monomer having at least one carboxyl group in the molecule with a comonomer copolymerizable therewith.
(2) A radiation-curable composition which comprises (A) the binder polymer, (B) the polyfunctional monomer and (C) the photo-radical generator consisting of the specific compound and further comprises an organic acid.
(3) A radiation-curable composition which comprises (A) the binder polymer, (B) the polyfunctional monomer and (C) the photo-radical generator consisting of the specific compound and further comprises a pigment.
(4) A radiation-curable composition selected from the above compositions (1)-(3), which is used in the production of a color filter.

Since the radiation-curable composition of this invention contains the photo-radical generator (C) consisting of the specific compound, the curing reaction of the composition is sufficiently achieved by irradiation with a small energy amount of a radiation, and therefore, a development treatment can be easily conducted without leaving any undissolved substance, whereby the production of a color filter composed of undercut-free pixels can be produced with certainty in a high efficiency.

### DESCRIPTION OF PREFERRED EMBODIMENTS

Examples are shown below to explain this invention in more detail.

Using 50 parts by weight of a methacrylic acid/benzyl methacrylate/polystyrene macromonomer copolymer (weight composition ratio: 25/65/10, weight average molecular weight: 55,000) as the component (A), 40 parts by weight of dipentaerythritol pentaacrylate as the component (B), 20 parts by weight of bis(2,6-dimethoxybenzoyl)-2,4,4-trimethylpentylphosphine oxide and 60 parts by weight of 2-hydroxy-2-methyl-1-phenylpropan-1-one as the component (C), 700 parts by weight of diethylene glycol dimethyl ether as the component (D), 5 parts by weight of citraconic acid as the component (E) and 90 parts by weight of a pigment (C.I. Pigment Green 7), a radiation-curable composition was produced (referred to hereinafter as the radiation-curable composition 1).

Subsequently, light screen layers were formed so as to partition pixel-forming portions on the surface of a soda-lime glass-made substrate having formed thereon a silica (SiO₂) film for preventing sodium ions from being dissolved out, and the radiation-curable composition 1 was coated on the surface of the substrate having the lightproof layers by means of a spin coater and prebaked at 80°C for 2 minutes, thereby forming a coating film having a film thickness of 2 µm.

This substrate was cooled and thereafter the coating film of the substrate was irradiated through a photomask with 100 mJ/cm² of ultraviolet rays including lights having wavelengths of 365 nm, 405 nm and 436 nm for 1 minute using a high pressure mercury lamp to effect radiation treatment. Subsequently, the thus treated substrate was immersed in a 0.1% by weight aqueous tetramethylammonium hydroxide solution at 25°C for 1 minute to effect development treatment. Thereafter, the thus treated substrate was washed with super pure water, then air-dried and further post-baked at 180°C for 30 minutes, to form a green pixel array composed of green pixels each having a size of 20 µm x 20 µm.

The thus treated substrate was observed through a light microscope to find no undissolved substance left on the substrate. Also, the yield of residual film thickness of the pixel array formed was as good as 92%, and the cross-sections of the pixels were observed by means of a scanning electron microscope to find no undercut.

### Example 2

Using 50 parts by weight of a methacrylic acid/benzyl methacrylate/hydroxyethyl methacrylate/polystyrene macromonomer copolymer (weight composition ratio: 12.5/ 65/12.5/10, weight average molecular weight: 25,000) as the component (A), 40 parts by weight of dipentaerythritol pentaacrylate as the component (B), 24 parts by weight of bis(2,6-dimethoxybenzoyl)-2,4,4-trimethylpentylphosphine oxide as the component (C), 790 parts by weight of 3-ethoxypropionic acid as the component (D), 6 parts by weight of malonic acid as the component (E) and 90 parts by weight of a pigment (C.I. Pigment Green 7), a radiation-curable composition was produced (referred to hereinafter as the radiation-curable composition2 ).

Subsequently, the same procedure as in Example 1 was repeated, except that the radiation-curable composition 2 was substituted for the radiation-curable composition 1 to form a green pixel array.

The thus treated substrate was observed through a light microscope to find no undissolved substance left on the substrate. Also, the yield of residual film thickness of the pixel array formed was as good as 95%, and the cross-sections of the pixels were observed by means of a scanning electron microscope to find no undercut.

### Comparative Example 1

Using 50 parts by weight of a methacrylic acid/benzyl methacrylate/styrene copolymer (weight composition ratio: 25/65/10, weight average molecular weight: 40,000) as the binder polymer, 40 parts by weight of trimethylolpropane triacrylate as the radical-polymerizable monomer, 24 parts by weight of 1-hydroxy-cyclohexylphenyl as the photo-radical generator, 790 parts by weight of ethyl Cellosolve acetate as the organic solvent and 90 parts by weight of a pigment (C.I. Pigment Red 177), a radiation-curable composition was produced (referred to hereinafter as the radiation-curable composition 6).

Subsequently, the same procedure as in Example 1 was repeated, except that the radiation-curable composition 6 was substituted for the radiation-curable composition 1 to form a red pixel array.

The thus treated substrate was observed through a light microscope to find some undissolved substances left on the substrate. The yield of residual film thickness of the pixel array formed was as low as 75%, and the cross-sections of the pixels were observed by means of a scanning electron microscope to find undercut.

### Example 3

Using 50 parts by weight of a methacrylic acid/benzyl methacrylate/polystyrene macromonomer copolymer (weight composition ratio: 25/65/10, weight average molecular weight: 55,000) as the component (A), 40 parts by weight of dipentaerythritol pentaacrylate as the component (B), 20 parts by weight of bis(2,6-dimethoxybenzoyl)-2,4,4-trimethylpentylphosphine oxide and 60 parts by weight of 2-hydroxy-2-methyl-1-phenylpropan-1-one as the component (C), 700 parts by weight of diethylene glycol dimethyl ether as the component (D), 5 parts by weight of citraconic acid as the component (E) and 90 parts by weight of a pigment (C.I. Pigment Black 1), a radiation-curable composition was produced (referred to hereinafter as the radiation-curable composition 3).

Subsequently, the same procedure as in Example 1 was repeated, except that the radiation-curable composition 3 was substituted for the radiation-curable composition 1 to form a black pixel array.

The thus treated substrate was observed through a light microscope to find no undissolved substance left on the substrate. Also, the yield of residual film thickness of the pixel array formed was as good as 90%, and the cross-sections of the pixels were observed by means of a scanning electron microscope to find no undercut.

### Example 4

Using 50 parts by weight of a methacrylic acid/benzyl methacrylate/hydroxyethyl methacrylate/polystyrene macromonomer copolymer (weight composition ratio: 12.5/ 65/12.5/10, weight average molecular weight: 25,000) as the component (A), 40 parts by weight of dipentaerythritol pentaacrylate as the component (B), 24 parts by weight of bis(2,6-dimethoxybenzoyl)-2,4,4-trimethylpentylphosphine oxide as the component (C), 790 parts by weight of 3-ethoxypropionic acid as the component (D), 6 parts by weight of malonic acid as the component (E) and 90 parts by weight of a pigment (C.I. Pigment Black 6), a radiation-curable composition was produced (referred to hereinafter as the radiation-curable composition 4 ).

Subsequently, the same procedure as in Example 1 was repeated, except that the radiation-curable composition 3 was substituted for the radiation-curable composition 1 to form a black pixel array.

The thus treated substrate was observed through a light microscope to find no undissolved substance left on the substrate. Also, the yield of residual film thickness of the pixel array formed was as good as 91%, and the cross-sections of the pixels were observed by means of a scanning electron microscope to find no undercut.

## Claims

1. A radiation-curable composition comprising (A) a binder polymer, (B) a polyfunctional monomer and (C) a photo-radical generator consisting of a compound represented by the following formula: 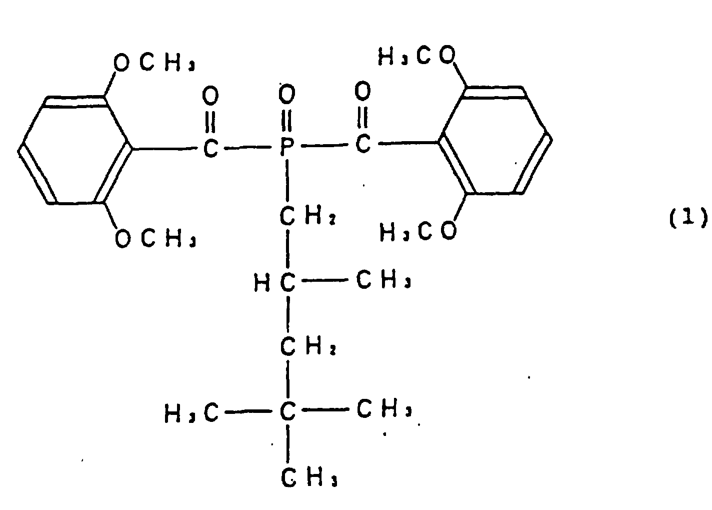 wherein the binder polymer (A) is a carboxyl group-containing copolymer obtained by polymerizing a monomer composition consisting of (A-1) a carboxyl-containing, ethylenically unsaturated monomer and (A-2) a comonomer copolymerizable with the carboxyl-containing, ethylenically unsaturated monomer (A-1),
the monomer (A-1) being methacrylic acid, and the comonomer (A-2) being (A-2-1) benzyl methacrylate and (A-2-2) at least one member selected from the group consisting of polystyrene macromonomer having a terminal acrylol or methacryloyl group and hydroxy ethyl methacrylate.

2. The radiation-curable composition according to Claim 1, wherein the proportion of the carboxyl-containing, ethylenically unsaturated monomer (A-1) copolymerized is 10 to 40% by weight based on the total weight of the binder polymer (A).

3. The radiation-curable composition according to Claim 1, wherein the binder polymer (A) has a weight average molecular weight of 5,000 to 100,000.

4. The radiation-curable composition according to Claim 1, wherein the polyfunctional monomer (B) is a trifunctional or more polyfunctional acrylate or an oligomer thereof.

5. The radiation-curable composition according to Claim 4, wherein the polyfunctional monomer (B) is selected from the group consisting of trimethylolpropane triacrylate, dipentaerythritol pentaacrylate and pentaerythritol triacrylate.

6. The radiation-curable composition according to Claim 1, wherein the proportion of the polyfunctional monomer (B) is 20 to 300 parts by weight per 100 parts by weight of the binder polymer (A).

7. The radiation-curable composition according to Claim 1, wherein the proportion of the photo-radical generator (C) is 1 to 120 parts by weight per 100 parts by weight of the polyfunctional monomer (B).

8. The radiation-curable composition according to Claim 1, which further contains (D) an organic solvent and is in the form of a solution or dispersion in the organic solvent (D).

9. The radiation-curable composition according to Claim 8 , wherein the organic solvent (D) is contained in a proportion of 500 to 5,000 parts by weight per 100 parts by weight of the binder polymer (A).

10. The radiation-curable composition according to Claim 1, which further contains (E) an organic acid.

11. The radiation-curable composition according to Claim 10, wherein the organic acid (E) is selected from the group consisting of adipic acid, malonic acid, citraconic acid, itaconic acid, mesaconic acid, fumaric acid and phthalic acid.

12. The radiation-curable composition according to Claim 10, which further contains the organic acid (E) in a proportion of 0.01 to 1% by weight per 100 parts by weight of the total weight of the composition including the organic solvent (D).

13. A color filter produced using a radiation-curable composition which comprises (A) a binder polymer, (B) a polyfunctional monomer (B) and a photo-radical generator consisting of a compound represented by the following formula: 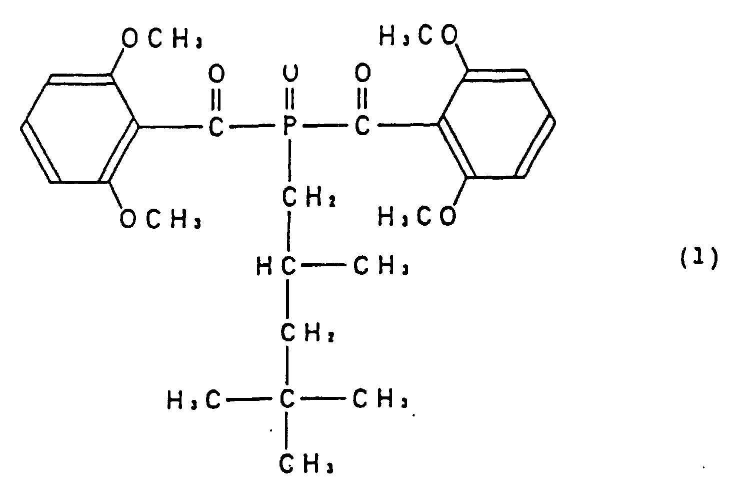 wherein the binder polymer (A) is a carboxyl group-containing copolymer obtained by polymerizing a monomer composition consisting of (A-1) a carboxyl-containing, ethylenically unsaturated monomer and (A-2) a comonomer copolymerizable with the carboxyl-containing, ethylenically unsaturated monomer (A-1), the monomer (A-1) being methacrylic acid, and the comonomer (A-2) being (A-2-1) benzyl methacrylate and (A-2-2) at least one member selected from the group consisting of polystyrene macromonomer having a terminal acryloyl or methacryloyl group and hydroxy ethyl methacrylate.

14. The color filter according to Claim 13, wherein the radiation-curable composition further comprises a pigment.

## Patentansprüche

1. Durch Strahlen härtbare Zusammensetzung, die (A) ein Bindemittelpolymer, (B) ein polyfunktionales Monomer und (C) ein photoradikalisches Erzeugungselement, das aus einer Verbindung besteht, die durch die folgende Formel dargestellt ist: 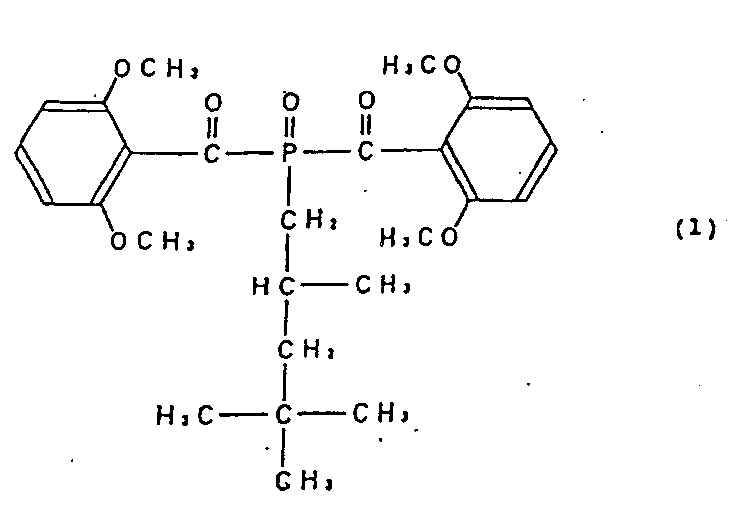 enthält, worin das Bindemittelpolymer (A) ein Carboxylgruppen enthaltendes Copolymer ist, das durch Polymerisation einer Monomerzusammensetzung hergestellt wird, die aus (A-1) einem Carboxyl enthaltenden, ethylenisch ungesättigten Monomer und (A-2) einem Comonomer, das mit dem Carboxyl enthaltenden, ethylenisch ungesättigten Monomer (A-1) copolymerisierbar ist, besteht,
wobei das Monomer (A-1) Methacrylsäure ist und das Comonomer (A-2) (A-2-1) Benzylmethacrylat ist und (A-2-2) mindestens ein Element ist, das aus der Gruppe gewählt ist, das aus einem Polystyrolmakromonomer mit einer endständigen Acryloyl- oder Methacryloylgruppe und Hydroxyethylmethacrylat besteht.

2. Durch Strahlen härtbare Zusammensetzung nach Anspruch 1, worin die Menge des Carboxyl enthaltenden, ethylenisch ungesättigten Monomers (A-1), das copolymerisiert wird, 10 bis 40 Gew.-%, bezogen auf das Gesamtgewichts des Bindemittelpolymers (A) beträgt.

3. Durch Strahlen härtbare Zusammensetzung nach Anspruch 1, worin das Bindemittelpolymer (A) ein gewichtsmittleres Molekulargewicht von 5.000 - 100.000 aufweist.

4. Durch Strahlen härtbare Zusammensetzung nach Anspruch 1, worin das polyfunktionale Monomer (B) ein trifunktionales oder ein polyfunktionales Acrylat oder ein Oligomer davon ist.

5. Durch Strahlen härtbare Zusammensetzung nach Anspruch 4, worin das polyfunktionale Monomer (B) aus der Gruppe gewählt ist, die aus Trimethylolpropantriacrylat, Dipentaerythritpentaacrylat und Pentaerythrittriacrylat gewählt ist.

6. Durch Strahlen härtbare Zusammensetzung nach Anspruch 1, worin die Menge des polyfunktionalen Monomers (B) 20 bis 300 Gew.-teile pro 100 Gew.-teile des Bindemittelpolymers (A) beträgt.

7. Durch Strahlen vernetzbare Zusammensetzung nach Anspruch 1, worin die Menge des photoradikalischen Erzeugungselements (C) 1 bis 120 Gew.-teile pro 100 Gew.-teile des polyfunktionalen Monomers (B) beträgt.

8. Durch Strahlen härtbare Zusammensetzung nach Anspruch 1, die weiterhin (D) ein organisches Lösungsmittel enthält und in Form einer Lösung oder Dispersion in dem organischen Lösungsmittel (D) vorliegt.

9. Durch Strahlen härtbare Zusammensetzung nach Anspruch 8, worin das organische Lösungsmittel (D) in einer Menge von 500 bis 5.000 Gew.-teilen pro 100 Gew.-teile des Bindemittelpolymers (A) enthalten ist.

10. Durch Strahlen härtbare Zusammensetzung nach Anspruch 1, die weiterhin (E) eine organische Säure enthält.

11. Durch Strahlen härtbare Zusammensetzung nach Anspruch 10, worin die organische Säure (E) aus der Gruppe gewählt ist, die aus Adipinsäure, Malonsäure, Citraconsäure, Itaconsäure, Mesaconsäure, Fumarsäure und Phthalsäure gewählt ist.

12. Durch Strahlen härtbare Zusammensetzung nach Anspruch 10, die weiterhin die organische Säure (E) in einer Menge von 0,01 bis 1 Gew.-% pro 100 Gew.-% des Gesamtgewichts der Zusammensetzung einschließlich das organische Lösungsmittel (D) enthält.

13. Farbfilter, das mit einer durch Strahlen härtbaren Zusammensetzung hergestellt ist, die (A) ein Bindemittelpolymer, (B) ein polyfunktionales Monomer (B) und ein photoradikalisches Erzeugungselement, das aus einer Verbindung besteht, die durch die folgende Formel dargestellt ist: 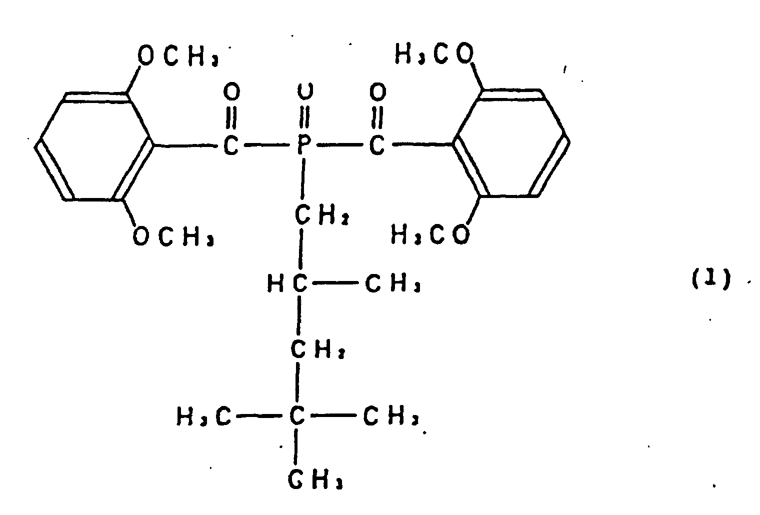 enthält, worin das Bindemittelpolymer (A) ein Carboxylgruppen enthaltendes Copolymer ist, das durch Polymerisation einer Monomerzusammensetzung hergestellt wird, die aus (A-1) einem Carboxyl enthaltenden, ethylenisch ungesättigten Monomer und (A-2) einem Comonomer, das mit dem Carboxyl enthaltenden, ethylenisch ungesättigten Monomer (A-1) copolymerisierbar ist, besteht,
wobei das Monomer (A-1) Methacrylsäure ist und das Comonomer (A-2) (A-2-1) Benzylmethacrylat ist und (A-2-2) mindestens ein Element ist, das aus der Gruppe gewählt ist, die aus einem Polystyrolmakromonomer mit einer endständigen Acryloyl- oder Methacryloylgruppe und Hydroxyethylmethacrylat besteht.

14. Farbfilter nach Anspruch 13, worin die durch Strahlen härtbare Zusammensetzung weiterhin ein Pigment enthält.

## Revendications

1. Composition réticulable par irradiation, comprenant (A) un liant polymère, (B) un monomère polyfonctionnel, et (C) un générateur de photo-radicaux constitué d'un composé représenté par la formule suivante : 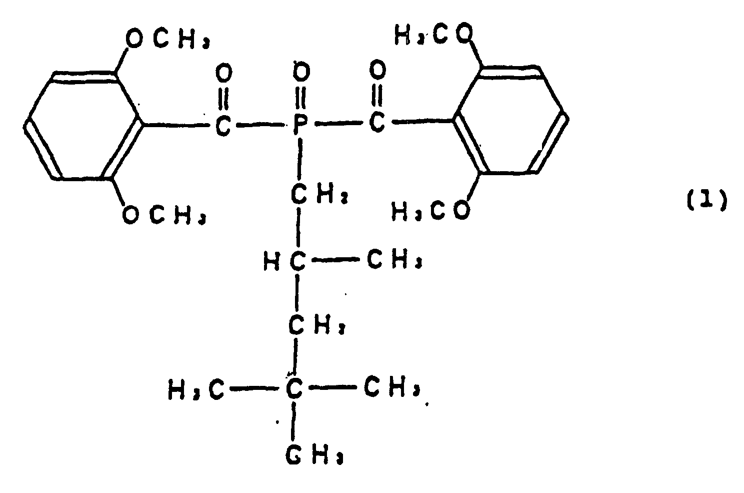 dans laquelle le liant polymère (A) est un copolymère contenant un groupe carboxyle, obtenu en polymérisant une composition de monomères à base de (A-1) un monomère à insaturation éthylénique contenant un carboxyle, et (A-2) un comonomère copolymérisable avec le monomère à insaturation éthylénique contenant un carboxyle (A-1), le monomère (A-1) étant de l'acide méthacrylique, et le comonomère (A-2) étant (A-2-1) du méthacrylate de benzyle, et (A-2-2) au moins un élément choisi dans le groupe constitué d'un macromonomère du polystyrène comportant un groupe acryloyle ou méthacryloyle terminal, et du méthacrylate d'hydroxyéthyle.

2. Composition réticulable par irradiation selon la revendication 1, dans laquelle la proportion de monomère à insaturation éthylénique contenant un carboxyle (A-1), copolymérisée, est de 10 à 40 % en poids sur la base du poids total de liant polymère (A).

3. Composition réticulable par irradiation selon la revendication 1, dans laquelle le liant polymère (A) a une masse moléculaire moyenne en poids de 5 000 à 100 000.

4. Composition réticulable par irradiation, selon la revendication 1, dans laquelle le monomère polyfonctionnel (B) est un acrylate trifonctionnel ou à fonctionnalité supérieure, ou bien un oligomère de celui-ci.

5. Composition réticulable par irradiation selon la revendication 4, dans laquelle le monomère polyfonctionnel (B) est choisi dans le groupe constitué du triacrylate de triméthylolpropane, du pentacrylate de dipentaérythritol, et du triacrylate de pentaérythritol.

6. Composition réticulable par irradiation selon la revendication 1, dans laquelle la proportion de monomère polyfonctionnel (B) est de 20 à 300 parties en poids pour 100 parties en poids de liant polymère (A).

7. Composition réticulable par irradiation selon la revendication 1, dans laquelle la proportion de générateur de photo-radicaux (C) est de 1 à 120 parties en poids pour 100 parties en poids de monomère polyfonctionnel (B).

8. Composition réticulable par irradiation selon la revendication 1, qui contient également (D) un solvant organique, et qui se présente sous la forme d'une solution ou d'une dispersion dans le solvant organique (D).

9. Composition réticulable par irradiation selon la revendication 8, dans laquelle le solvant organique (D) est présent dans une proportion de 500 à 5 000 parties en poids pour 100 parties en poids du liant polymère (A).

10. Composition réticulable par irradiation selon la revendication 1, qui contient également (E) un acide organique.

11. Composition réticulable par irradiation selon la revendication 10, dans laquelle l'acide organique (E) est choisi dans le groupe constitué de l'acide adipique, de l'acide malonique, de l'acide citraconique, de l'acide itaconique, de l'acide mésaconique, de l'acide fumarique, et de l'acide phtalique.

12. Composition réticulable par irradiation selon la revendication 10, laquelle contient également l'acide organique (E) dans une proportion de 0,01 à 1 % en poids pour 100 parties en poids de la masse totale de la composition y compris le solvant organique (D).

13. Filtre coloré préparé en utilisant une composition réticulable par irradiation qui comprend (A) un liant polymère, (B) un monomère polyfonctionnel (B), et un générateur de photo-radicaux constitué d'un composé représenté par la formule suivante : 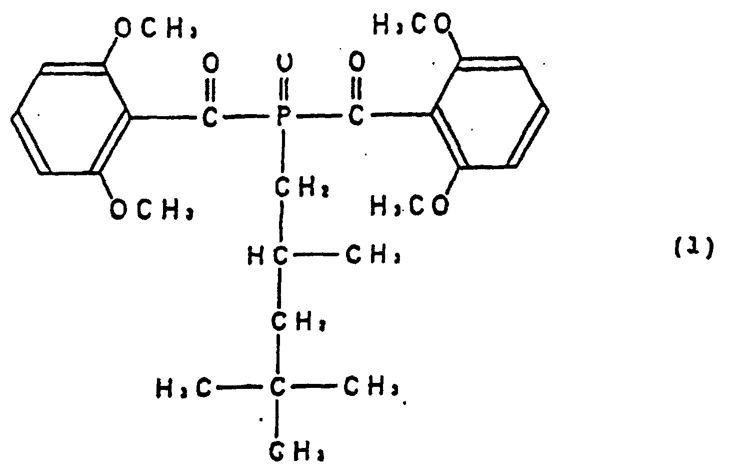 dans laquelle le liant polymère (A) est un copolymère contenant un groupe carboxyle, obtenu en polymérisant une composition de monomères à base de (A-1) un monomère à insaturation éthylénique contenant un carboxyle, et (A-2) un comonomère copolymérisable avec le monomère à insaturation éthylénique contenant un carboxyle (A-1), le monomère (A-1) étant l'acide méthacrylique, et le comonomère (A-2) étant (A-2-1) du méthacrylate de benzyle, et (A-2-2) au moins un élément choisi dans le groupe constitué d'un macromonomère du polystyrène comportant un groupe acryloyle ou méthacryloyle terminal, et du méthacrylate d'hydroxyéthyle.

14. Filtre coloré selon la revendication 13, dans lequel la composition réticulable par irradiation comprend également un pigment.
